Europäisches Patentamt

European Patent Office

Office européen des brevets

(19)

(11) EP 0 753 756 A2

(12) **EUROPÄISCHE PATENTANMELDUNG**

(43) Veröffentlichungstag:
 15.01.1997 Patentblatt 1997/03

(51) Int. Cl.⁶: $G01R\ 27/26$

(21) Anmeldenummer: 96110443.7

(22) Anmeldetag: 27.06.1996

(84) Benannte Vertragsstaaten:
 **DE FR GB IT SE**

(30) Priorität: **04.07.1995 DE 19524387**

(71) Anmelder: **SIEMENS AKTIENGESELLSCHAFT**
 **80333 München (DE)**

(72) Erfinder:
 • **Tielert, Reinhard, Prof. Dr.**
  **67722 Winnweiler (DE)**
 • **Hildebrandt, Andreas**
  **67346 Speyer (DE)**

(54) **Schaltungsanordnung und Verfahren zum Messen eines Kapazitätsunterschiedes zwischen einer ersten Kapazität C1 und einer zweiten Kapazität C2**

(57)  Durch isolierte Messung einer Störkapazität ($C_P$), durch die parasitäre Effekte modelliert werden, denen die erste Kapazität ($C_1$) und die zweite Kapazität ($C_2$) unterliegen, in einer Meßlogik (ML) ist eine bisher notwendige Kompensation mehrerer parasitärer Effekte unnötig geworden.

 Wenn eine in digitaler Form realisierte Auswertelogik (AL) verwendet wird, braucht nur eine Zählereinheit vorgesehen sein, in der ein zu der jeweils gemessenen Kapazität proportionaler Binärwert gezählt wird.

 Durch zyklisches Messen der Störkapazität ($C_P$), der ersten Kapazität ($C_1$), der zweiten Kapazität ($C_2$) und zum Schluß der Störkapazität ($C_P$), wird die Störkapazität ($C_P$) kompensiert, wenn die Zählereinheit jeweils bei "Zählung" der Störkapazität ($C_P$) rückwärts, und sonst vorwärts zählt. Jeder Teilyklus (T1, T2, T3, T4) dauert genau N Takte lang, wobei die Takte von einem Meßoszillator (MO) geliefert werden. Die Takte sind abhängig von der jeweils gemessenen Kapazität.

FIG 1

**Beschreibung**

Die Messung kleiner Kapazitäten ist eine immer wiederkehrende Aufgabenstellung z. B. bei der Auswertung von kapazitiven Sensoren. Probleme bei der Messung kleiner Kapazitäten treten vor allem durch parasitäre Effekte auf, die bei der Messung kompensiert werden müssen.

Durch das Dokument EP 0 166 706 B1 ist ein Verfahren zur Messung von Kapazitäten bekannt, bei dem eine zu messende Kapazität und eine Referenzkapazität alternierend nacheinander an Eingangsanschlüsse eines Meßoszillators angeschlossen werden. Das in diesem Dokument beschriebene Verfahren birgt einige Nachteile in sich. Bei Kondensatoren mit sehr geringen Kapazitätswerten wird die Empfindlichkeit der Schaltung durch zusätzliche Kapazitäten reduziert. Die vorgeschlagenen Gegenmaßnahmen beinhalten einen erhöhten Aufwand, zusätzliche Temperaturdrift, falls die Spannung des Ausgangspuffers nicht ebenfalls temperaturkompensiert ist, sowie eine Reduzierung des Störabstandes bzw. der Auflösung.

Ferner sind verschiedene Verfahren und Schaltungsanordnungen zum Messen einer Kapazität bzw. eines Kapazitätsunterschiedes von kleinen Kapazitäten bekannt (EP 0 166 705 A2; DE 35 19 390 C2; DE 43 13 327 A1; DE 39 19 191 A1).

Die in dem Dokument EP 0 166 706 B1 vorgeschlagene Lösung zur Temperaturkompensation, eine zusätzliche Kapazität zu verwenden, vergrößert das nichtlineare Verhalten des Verfahrens. Außerdem wird dadurch die Empfindlichkeit reduziert und die zusätzliche Kapazität muß hinsichtlich ihrer Größe als auch ihres Temperaturkoeffizienten individuell ausgewählt werden.

Auch wird in dem Dokument zur Unterdrückung von Störungen, die durch das Umschalten der Kapazitäten bedingt sind, vorgeschlagen, die Teilerzahl N ausreichend groß zu wählen. Dies führt zu einer längeren Meßzeit, was einen weiteren Nachteil des Verfahrens darstellt.

Der Erfindung liegt das Problem zugrunde, eine Schaltungsanordnung zum Messen eines Kapazitätsunterschiedes zwischen zwei Kapazitäten anzugeben, die die im vorigen beschriebenen Probleme vermeidet. Weiterhin liegt der Erfindung das Problem zugrunde, ein Verfahren anzugeben zur Messung eines Kapazitätsunterschiedes zwischen zwei Kapazitäten, das die im vorigen beschriebenen Probleme vermeidet.

Das Problem wird durch die erfindungsgemäße Schaltungsanordnung gemäß Patentanspruch 1 und das Verfahren gemäß Patentanspruch 7 gelöst.

Durch die erfindungsgemäße Schaltungsanordnung sowie durch das erfindungsgemäße Verfahren werden spezielle Maßnahmen zur Kompensation der Temperaturdrift unnötig. Außerdem wird die Empfindlichkeit durch parasitäre Effekte nicht reduziert. Durch die Weiterbildung der Schaltungsanordnung gemäß Patentanspruch 2 ist eine Variation der Auflösung der Ergebnisausgabe möglich, wodurch eine benutzerspezifische Variation zwischen erwünschter Geschwindigkeit bzw. gewünschter Auflösung der Schaltungsanordnung ermöglicht wird. Durch die Weiterbildung der Schaltungsanordnung nach Anspruch 3 und der Weiterbildung des Verfahrens nach Anspruch 9 wird das Meßergebnis in digitaler Form zur Verfügung gestellt. Dadurch ist eine problemlose Adaption an ein Microcontrollersystem möglich. Außerdem wird erreicht, daß keine hochgenauen oder hochstabilen Analogkomponenten erforderlich sind.

Weiterbildungen der Erfindung ergeben sich aus den abhängigen Ansprüchen.

Ein bevorzugtes Ausführungsbeispiel der Erfindung ist in den Zeichnungen dargestellt und wird im folgenden näher beschrieben.

Es zeigen

Figur 1     ein Blockschaltbild der gesamten Schaltungsanordnung, bestehend aus einer Meßlogik und einer Auswertelogik;

Figur 2     ein Blockschaltbild, das die Meßlogik beschreibt;

Figur 3     ein Blockschaltbild, das den Meßoszillator der Meßlogik beschreibt;

Figur 4     eine Skizze, die ein Modell des Stromschalters in Form zweier Stromquellen unterschiedlicher Polarität darstellt;

Figur 5     ein Blockschaltbild, das den Periodenzähler der Meßlogik darstellt;

Figur 6     eine Skizze, die die Änderung der Bitbreite des Periodenzählers beschreibt;

Figur 7     ein Blockschaltbild, das den Aufbau der Auswertelogik darstellt;

Figur 8     ein Blockschaltbild, das das Operationswerk der Auswertelogik beschreibt;

Figur 9     ein Blockschaltbild, das das Steuerwerk der Auswertelogik beschreibt;

Figur 10    ein Blockschaltbild, das den in dem Operationswerk vorhandenen Asynchronzähler darstellt;

Figur 11    ein Schaltbild des Asynchronzählers;

Figur 12    ein Blockschaltbild eines Zählerbausteins, der in dem Asynchronzähler verwendet wird;

Figur 13    ein Ablaufdiagramm, das den Ablauf eines Meßzyklus beschreibt;

Figur 14    ein Blockschaltbild, das eine mögliche Vorgehensweise zur Berechnung des Kapazitätsunterschiedes zwischen zwei Kapazitäten beschreibt, die dem Einfluß einer Störgröße unterliegen;

Figur 15    ein Blockschaltbild, das eine modifizierte Vorgehensweise zur Berechnung des Kapazitätsunterschiedes zwischen zwei Kapazitäten beschreibt, die dem Einfluß einer Störgröße unterliegen.

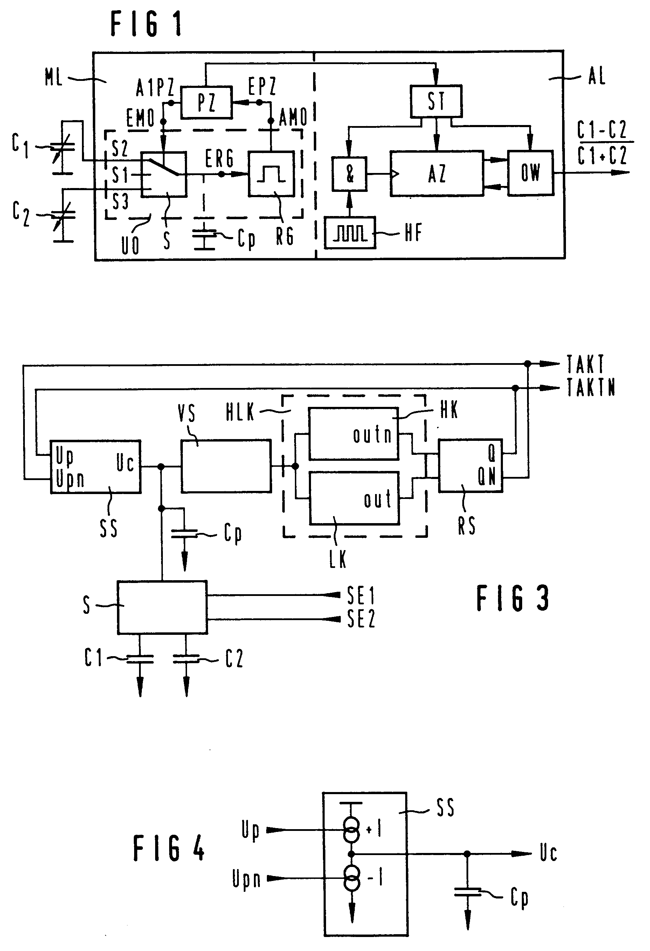

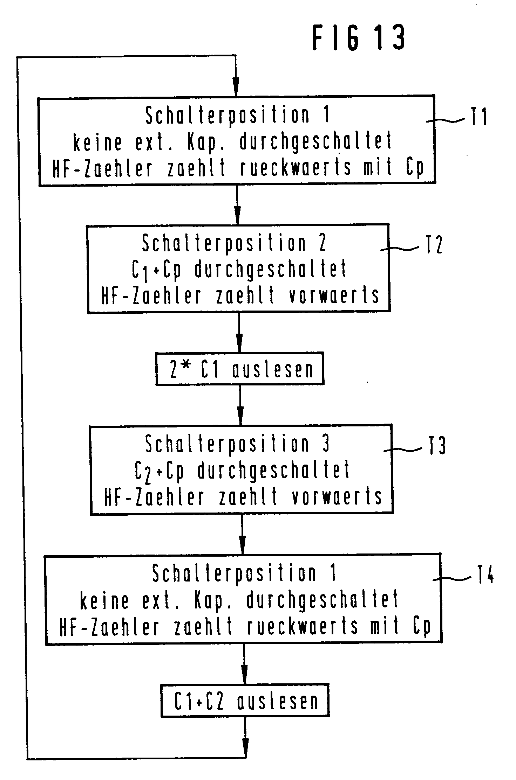

Anhand der Figuren 1 bis 15 wird die erfindungsgemäße Schaltungsanordnung und das erfindungsgemäße Verfahren weiter erläutert.

In Figur 1 ist mit Hilfe eines Blockschaltbildes die Schaltungsanordnung des im weiteren beschriebenen bevorzugten Ausführungsbeispiels dargestellt. Die Schaltungsanordnung weist eine Meßlogik ML und eine Auswertelogik AL auf.

**Meßlogik ML**

Die Meßlogik ML der Schaltungsanordnung hat die Funktion, eine erste Kapazität $C_1$ und eine zweite Kapazität $C_2$ in digital auswertbare Signale umzuwandeln. Gleichzeitig kann sie dafür verwendet werden, den Schalttakt für die Auswertelogik AL zu generieren, und ein Steuerwerk ST in der Auswertelogik AL mit Hilfe des Zählerstandes eines in der Meßlogik enthaltenen Periodenzählers PZ über den momentanen Zeitpunkt eines Meß-/Auswertevorganges zu informieren.

Die Meßlogik ML weist mindestens folgende Komponenten auf:

- Einen Meßoszillator MO, aufweisend einen Rechteck-Generator RG und eine Schaltereinheit S,
- den Periodenzähler PZ,
- eine Spannungsquelle REF.

Der Periodenzähler PZ ist über einen ersten Ausgang A1PZ des Periodenzählers PZ mit einem Eingang EMO des Meßoszillators MO gekoppelt. Ein Ausgang AMO des Meßoszillators ist mit einem Eingang EPZ des Periodenzählers PZ gekoppelt. Der Meßoszillators MO weist die Schaltereinheit S auf.

Die Schaltereinheit S weist drei unterschiedliche Schalterpositionen auf.

Bei einer ersten Schalterposition S1 ist der Schalter offen, d. h. er bleibt unbeschaltet. Damit ist ein Eingang ERG des Rechteck-Generators RG unbeschaltet, wodurch auftretende parasitäre Effekte, die durch eine parallel geschaltete Störkapazität $C_P$ modelliert werden können, isoliert von der ersten Kapazität $C_1$ und der zweiten Kapazität $C_2$ ermittelt werden.

In einer zweiten Schalterposition S2 ist die Schaltereinheit S mit der ersten Kapazität $C_1$ verbunden. Damit wird in dem Meßoszillator MO, der nun mit der ersten Kapazität $C_1$ gekoppelt ist, eine gestörte erste Kapazität $C_1'$ ermittelt, da die erste Kapazität $C_1$ unter dem Einfluß der Störkapazität $C_P$ ist.

In einer dritten Schalterposition S3 ist die Schaltereinheit S mit der zweiten Kapazität $C_2$ gekoppelt. In dieser Position kann von dem Meßoszillator eine gestörte zweite Kapazität $C_2'$, die sich aus der Summe der zweiten Kapazität $C_2$ und der Störkapazität $C_P$ ergibt, ermittelt werden.

Die Aufgabe des Rechteck-Generators RG liegt in der Generierung eines Rechtecksignals, dessen Frequenz abhängig ist von der an dem Eingang ERG des Rechteck-Generators RG anliegenden Kapazität. Die Frequenzabhängigkeit des Rechtecksignals von den anliegenden Kapazitäten kann z. B. proportional sein oder auch in einer anderen funktionalen Abhängigkeit von den anliegenden Kapazitäten bestehen.

Die Aufgabe des Periodenzählers PZ liegt in der Steuerung der Schaltereinheit S, d. h. in der Auswahl der Schalterposition und damit der Auswahl der zu messenden Kapazität und in der Koordination der Auswertelogik.

Eingänge Z0 bis Z2 einer Dekodierstufe DEC steuern die Stufenzahl des Periodenzählers PZ, falls eine variable Bitbreite des Periodenzählers PZ vorgesehen ist.

Durch die Spannungsquelle REF wird ein Off-Set für die erste Kapazität $C_1$ und die zweite Kapazität $C_2$ erzeugt.

Die in Figur 2 detailierter dargestellte Meßlogik ML ist in einen Analogteil AT und in einen Digitalteil DT gegliedert.

Der den Meßoszillator MO umfassende Analogteil AT übernimmt die Wandlung der zu messenden Kapazität, die jeweils durch die Schaltereinheit S an den Meßoszillator MO gekoppelt ist, in ein Rechtecksignal. Das Rechtecksignal taktet den Periodenzähler PZ, der sich im Digitalteil DT der Meßlogik ML befindet.

Der Periodenzähler PZ zählt die vom Meßoszillator MO generierten Takte und steuert über seine beiden höchstwertigen Bits die Schaltereinheit S.

Die Spannungsquelle REF ist vor allem vorteilhaft einsetzbar zur Reduzierung von elektrostatischen Störkräften auf die bewegliche Mittelelektrode, wenn die erste Kapazität C1 und die zweite Kapazität C2 Teilkapazitäten eines Differentialkondensators sind.

Rückwirkungen, die der Digitalteil DT auf den Analogteil AT hat, können durch Treiberstufen TS reduziert werden, die zwischen den Meßoszillator MO und den Digitalteil DT geschaltet sind.

Falls die Verwendung der Spannungsquelle REF vorgesehen ist, ist ein Anschluß C12COLD an die Massepunkte der ersten Kapazität $C_1$ und der zweiten Kapazität $C_2$ geschaltet, um störende elektrostatische Kräfte, die innerhalb der Schaltungsanordnung auftreten können, zu minimieren.

An zwei Anschlüsse RLEXT und RHEXT kann ein externer Widerstand angeschlossen sein, um den Lade-/Entladestrom der frequenzbestimmenden Kapazitäten zu steuern. Der Lade-/Entladestrom kann durch Verwendung des externen Widerstands vergrößert werden, wodurch auch größere Kapazitäten angeschlossen werden können.

## Rechteck-Generator RG

In Figur 3 ist eine Ausführungsform eines Rechteck-Generators RG dargestellt, der in der erfindungsgemäßen Schaltungsanordnung vorgesehen sein kann.

Jedem Fachmann sind weitere, von dem hier beschriebenen Rechteck-Generator RG verschiedene Rechteck-Generatoren bekannt, die ebenso in der erfindungsgemäßen Schaltungsanordnung vorgesehen sein können.

Aufgabe des vorgesehenen Rechteck-Generators RG ist lediglich die Generierung eines frequenzvariablen Rechtecksignals, wobei die Frequenz des Rechtecksignals abhängig ist von der Kapazität, die an dem Eingang ERG des Rechteck-Generators RG liegt.

Der hier beschriebene Rechteck-Generator RG weist folgenden Komponenten auf:

- Einen Stromschalter SS,
- einen Verstärker VS,
- einen High-Low-Pegel-Komparator HLK, und
- ein RS-Flip-Flop RS.

Der Stromschalter SS kann, wie in Figur 4 beschrieben, durch zwei Stromquellen unterschiedliche Polarität modelliert werden.

Solange ein erstes Eingangssignal Up auf High-Pegel (5 Volt) liegt, ist die positive Stromquelle +I aktiviert und lädt die Kapazität, die über die Schaltereinheit S mit dem Rechteck-Generator RG gekoppelt ist, auf. In diesem Fall liegt das negierte Eingangssignal Upn des Stromschalters SS auf Low-Potential (0 Volt).

Schaltet das Eingangssignal Up des Stromschalters SS auf Low-Potential (0 Volt), so wird die jeweils angeschlossene Kapazität über die negative Stromquelle -I entladen. In diesem Fall ist das negierte Eingangssignal Upn des Stromschalters SS auf High-Pegel (5 Volt).

Ein Ausgang des Stromschalters SS ist mit der Schaltereinheit S gekoppelt. Ebenso ist der Ausgang des Stromschalters SS mit einem Eingang des Verstärkers VS gekoppelt. Ein Ausgang des Verstärkers VS ist mit einem Eingang des High-Low-Pegel-Komparator HLK gekoppelt.

Ein erster Ausgang outn des High-Low-Pegel-Komparator HLK ist mit einem Set-Eingang des RS-Flip-Flops-RS gekoppelt. Ein zweiter Ausgang out des High-Low-Pegel-Komparators HLK ist mit einem Reset-Eingang des RS-Flip-Flops RS gekoppelt. Ein positiver Ausgang Q des RS-Flip-Flops RS ist rückgekoppelt an einen ersten Eingang des Stromschalters SS und liefert das Eingangssignal Up des Stromschalters SS. Dieses Eingangssignal Up des Stromschalters SS, das von dem RS-Flip-Flop RS geliefert wird, stellt gleichzeitig ein erstes Taktsignal TAKTN dar. Ein negierter Ausgang QN des RS-Flip-Flops RS ist mit einem zweiten Eingang des Stromschalters SS verbunden, an dem das negierte Eingangssignal Upn des Stromschalters SS anliegt. Das negierte Eingangssignal Upn des Stromschalters SS wird von dem RS-Flip-Flop RS geliefert und stellt gleichzeitig ein zweites Taktsignal TAKT dar.

Ein Ausgangssignal Uc des Stromschalters SS wird in der Verstärkerstufe VS verstärkt. Der High-Low-Pegel-Komparator HLK weist zwei Komparatoren auf, einen High-Pegel-Komparator HK und einen Low-Pegel-Komparator LK.

Der High-Pegel-Komparator HK vergleicht das anliegende Dreiecksignal mit einem Referenzspannungspegel von vorzugsweise 3 Volt und gibt im Falle des Überschreitens des anliegenden Dreiecksignals über den Referenzspannungspegel ein Low-Potential (0 Volt) an dem ersten Ausgang outn des High-Low-Pegel-Komparators HLK aus, im umgekehrten Fall ein High-Potential (5 Volt).

Der Low-Pegel-Komparator LK arbeitet mit einem Vergleichspotential von vorzugsweise 2 Volt und einem invertierten Ausgang.

Für jeden Fachmann ist es sofort ersichtlich, daß das Referenzpotential des High-Pegel-Komparators HK nicht unbedingt den Wert 3 Volt und das Referenzpotential des Low-Pegel-Komparators LK nicht unbedingt 2 Volt betragen muß, sondern die Referenzpotential können auch andere Werte annehmen.

Die Ausgangssignale des RS-Flip-Flops RS sind auf die Eingänge des Stromschalters SS zurückgekoppelt. Eine Periodendauer T des entstehenden Rechtecksignals und somit auch die Zeit, welche der Rechteck-Generator RG für N Schwingungen benötigt, hängt somit von der durch die Schaltereinheit S an den Rechteck-Generator RG angekoppelten Kapazität ab, in dem Fall des bevorzugten Ausführungsbeispiels sogar linear.

## Periodenzähler PZ

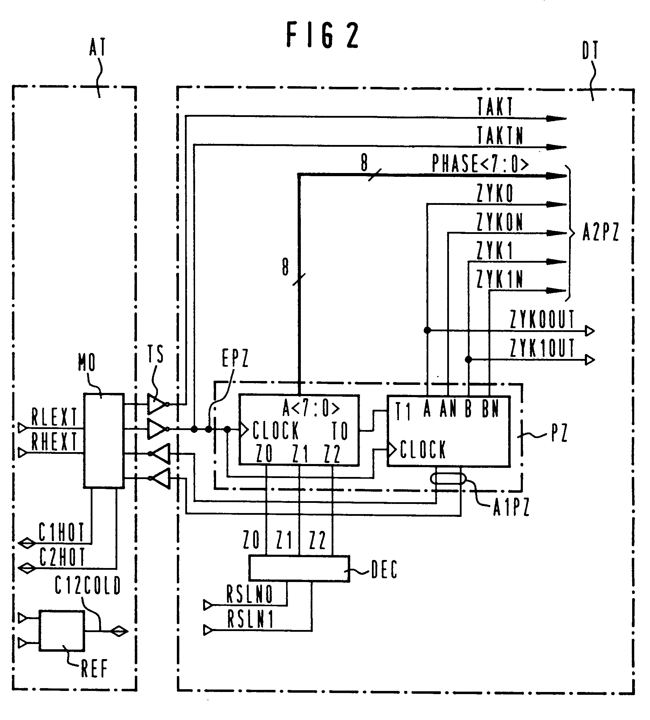

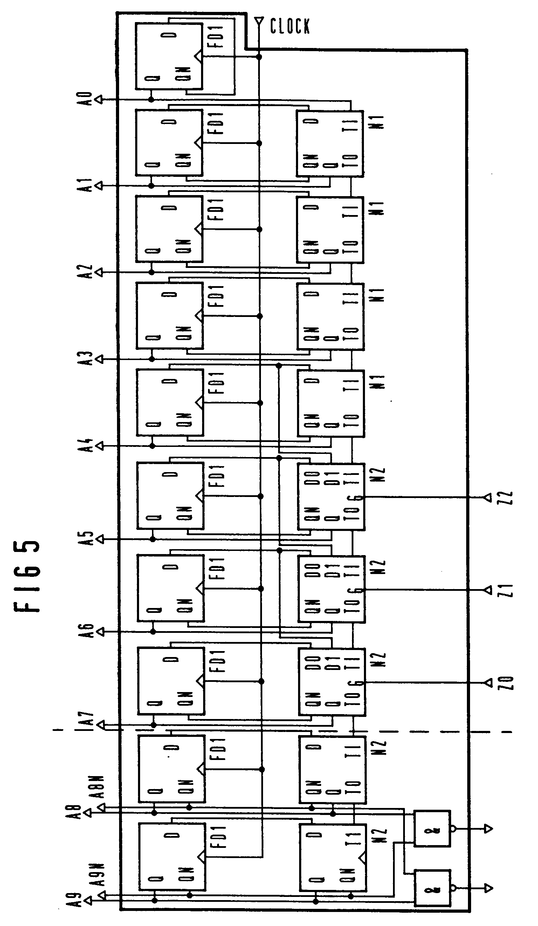

Der Periodenzähler PZ weist eine synchron arbeitende Zählerkette auf, wie sie z. B. in Figur 5 beschrieben ist. Die beiden höchstwertigen Bits des Periodenzählers PZ steuern die Schaltereinheit S und damit die Auswahl der zu messenden Kapazität. Somit stellt der Periodenzähler PZ einen Zykluszähler dar.

In Fällen in denen es weniger auf die größtmögliche Auflösung, als auf eine schnelle Messung ankommt, besteht die Möglichkeit, die Meßzeit zu reduzieren. Hierzu kann der Periodenzähler PZ in seiner Bitbreite variabel ausgelegt sein. Dadurch kann die Anzahl N der Takte und somit die Zeit pro Meßzyklus schrittweise halbiert werden. Die Anzahl der von einem im späteren beschriebenen Asynchronzähler AZ gezählten Impulse halbiert sich ebenfalls, was eine Verminderung der Auflösung der Messung zur Folge hat. Dies kann jedoch, wenn die Schnelligkeit der Messung wichtiger ist als die Auflösung der Messung, eventuell hingenommen werden.

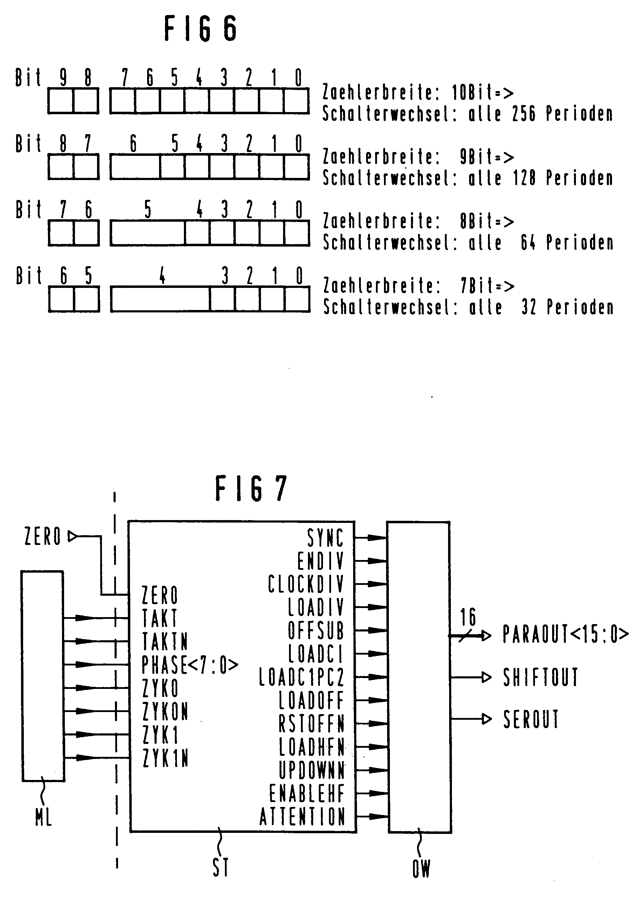

Die Variierung der Bitbreite des Periodenzählers PZ wird erreicht, indem ein siebtes Bit schrittweise mit den voranstehenden Bits gleichgeschaltet wird, wie in Figur 6 dargestellt. Daher halbiert sich jeweils der Teilfaktor N, wodurch sich eine kürzere Meßzeit auf Kosten einer verringerten Auflösung ergibt.

Erreicht wird die Verkürzung der Zählerkette mit Hilfe spezieller, steuerbarer Logikgatter N2. Steuereingänge Z0, Z1 und Z2 der steuerbaren Logikgatter N2 werden mit Hilfe der Dekodierstufe DEC auf zwei externe Steuereingänge RSLN0 und RSLN1 reduziert (vgl. Figur 2).

Die folgende Tabelle beschreibt die Variation der Bitbreite des Periodenzählers PZ in Abhängigkeit der Steuereingänge Z0, Z1 und Z2.

| Z0 | Z1 | Z2 | Zählerbreite | Takte/Meßzyklus |
|----|----|----|--------------|-----------------|
| 0 | 0 | 0 | 10 Bit | 1024 |
| 1 | 0 | 0 | Bit 7 und 6 sind gleichgeschaltet$\Rightarrow$9Bit | 512 |
| 1 | 1 | 0 | Bit 7,6 und 5 sind gleichgeschaltet$\Rightarrow$8Bit | 256 |
| 1 | 1 | 1 | Bit 7,6,5 und 4 sind gleichgeschaltet$\Rightarrow$7Bit | 128 |

Die Verschaltung der Elemente, die der Periodenzähler PZ aufweist, können der Figur 5 entnommen werden.

## Auswertelogik AL

Jeder Teilzyklus, der im weiteren beschrieben wird, erstreckt sich über eine Zeitdauer, welche von der gemessenen Kapazität abhängt.

Die Aufgabe der Auswertelogik AL besteht darin, der Zeitdauer einen proportionalen Binärwert zuzuordnen und aus den gewonnenen Werten den Kapazitätsunterschied zwischen der ersten Kapazität C1 und der zweiten Kapazität C2 zu berechnen. Dies geschieht durch Messung der für einen Teilzyklus benötigten Zeit mittels eines HF-Taktes.

Figur 7 beschreibt schematisch den Aufbau der Auswertelogik AL. Die Auswertelogik AL ist unterteilt in das Steuerwerk ST und ein Operationswerk OW.

In dem bevorzugten Ausführungsbeispiel ist die Auswertelogik AL in digitaler Form realisiert.

Jedem Fachmann ist es jedoch geläufig, daß die Auswertelogik AL auch in analoger Form realisiert sein kann. Somit beschränkt sich die Erfindung nicht auf eine digitale Auswertelogik AL, sondern umfaßt auch eine analoge Auswertelogik AL, deren Aufbau jedem Fachmann bekannt ist.

Da jedoch eine digitale Auswertelogik AL weitere Vorteile gegenüber einer analogen Auswertelogik AL aufweist, wird das bevorzugte Ausführungsbeispiel mit digitaler Auswertelogik AL beschrieben.

Die Tatsache, daß die Auswertlogik AL aus digitalen Bausteinen aufgebaut ist, birgt mehrere Vorteile in sich. Ein Vorteil liegt in einem vergleichweise geringen Hardware-Aufwand zur Realisierung der gesamten Schaltungsanordnung.

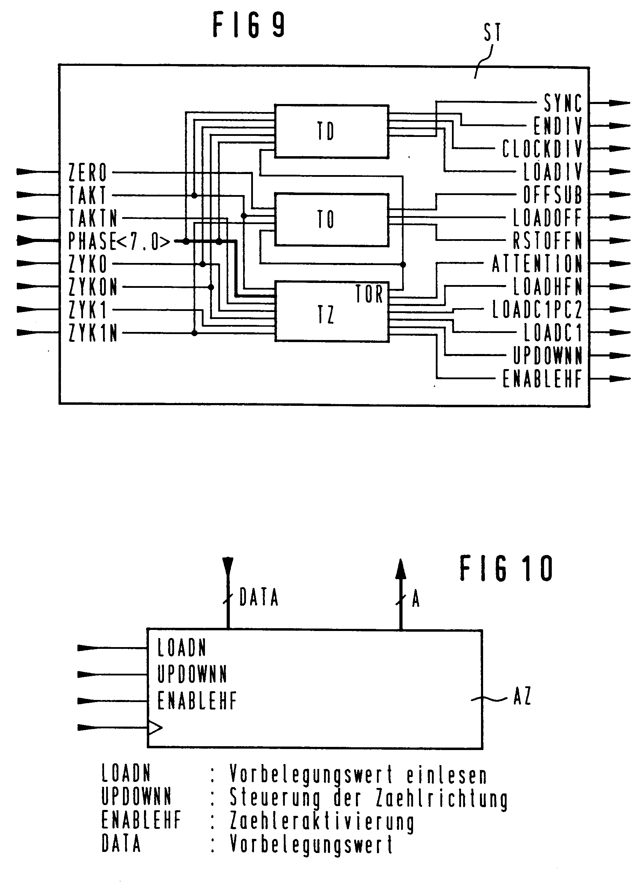

Weiterhin liegt ein Vorteil in der Ausgabe des Ergebnisses in digitaler Form, wodurch eine problemlose Adaption an ein Mikrocontrollersystem möglich ist. Das Steuerwerk ST, welches, wie in Figur 9 beschrieben, in drei Teilsteuerwerke aufgeteilt ist, übernimmt die Koordination der in dem Operationswerk OW durchgeführten Aktionen. Hierzu sind Eingänge des Steuerwerks ST mit der Meßlogik ML gekoppelt. Die Zuordnung der Eingänge zu den entsprechenden Anschlüssen bei der Meßlogik ML sind durch die in Figur 7 und Figur 2 dargestellten Bezugszeichen erkennbar.

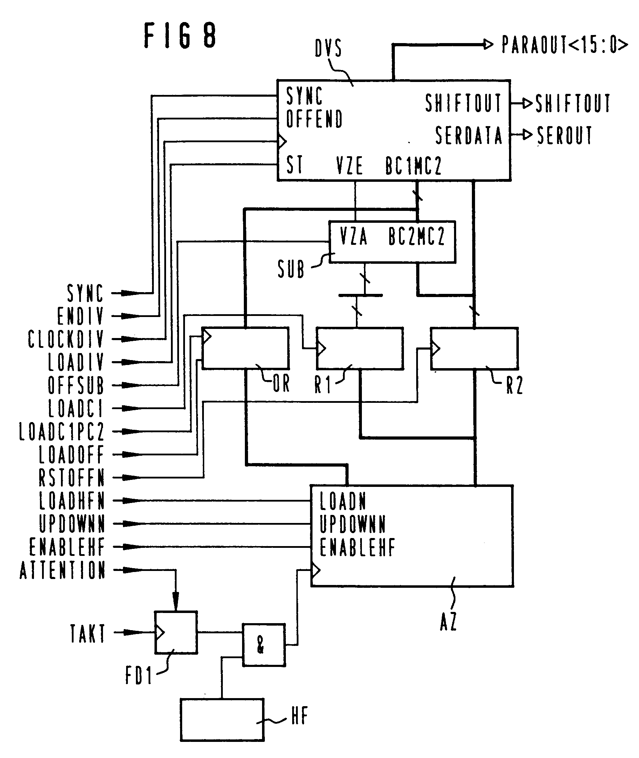

Ein erstes Teilsteuerwerk TD des Steuerwerks ST ist zuständig für die Steuerung einer Dividierstufe DVS, die sich im Operationswerk OW befindet (vgl. Figur 8).

Ein zweites Teilsteuerwerk TO steuert eine eventuell vorgesehene Offset-Kompensation.

Ein drittes Teilsteuerwerk TZ dient zur Steuerung des Asychronzählers AZ, der sich ebenfalls in dem Operationswerk OW befindet.

Die jeweiligen Steuersignale sind in Figur 9 und in Figur 8 angegeben, wodurch die verschiedenen Steuerungen ersichtlich sind.

Mit Hilfe eines D-Flip-Flops FD1 wird ein UND-Gatter & gesteuert, welches über einen zweiten Eingang mit einem Ausgang eines HF-Oszillators HF gekoppelt ist. Ein Ausgang des UND-Gatters & ist mit einem Zähleingang ZP des Asynchronzählers AZ gekoppelt.

Zur Realisierung des Asynchronzählers AZ kann selbstverständlich auch jeder beliebige andere Zähler verwendet werden, welcher Eingangssignale genügend hoher Frequenzen verarbeiten kann.

Die Zählrichtung des Asynchronzählers AZ wird über das Signal UPDOWNN von dem dritten Teilsteuerwerk TZ festgelegt (vgl. Figur 9 und Figur 10).

Der Asynchronzähler AZ ist außerdem mit einem bestimmten Startwert vorbelegbar. Bei einer eventuell vorgesehenen Offset-Kompensation besteht der Vorbelegungswert aus der negativen Differenz der ersten Kapazität $C_1$ und der zweiten Kapazität $C_2$. Ist keine Offset-Kompensation vorgesehen, so wird der Asynchronzähler AZ mit dem Wert 0 vorbelegt.

Wie aus Figur 8 ersichtlich, sind weiterhin drei Register in dem Operationswerk OW der Auswertelogik AL vorgesehen.

Ein Offset-Register OR ist mit einem Dateneingang DATA des Asynchronzählers AZ gekoppelt, sowie mit einem Ausgang BC2MC2 der Subtrahierstufe SUB. Der Ausgang BC2MC2 ist außerdem mit einem Eingang BC1MC2 einer Dividierstufe DVS gekoppelt.

Ein Vorzeichenausgang VZA der Subtrahierstufe SUB ist mit einem Vorzeicheneingang VZE der Dividierstufe DVS gekoppelt.

Ein erstes Register R1 ist gekoppelt mit einem zweiten Ausgang A des Asynchronzählers AZ. Außerdem ist das erste Register R1, in dem der Wert der ersten Kapazität $C_1$ gespeichert wird, mit einem ersten Eingang E1 der Subtrahierstufe SUB gekoppelt.

Ein zweiter Eingang der Subtrahierstufe SUB ist gekoppelt mit einem zweiten Register R2, in dem der Summenwert der ersten Kapazität $C_1$ und der zweiten Kapazität $C_2$, also der Wert $C_1 + C_2$ gespeichert ist. Das zweite Register R2 ist ebenso mit dem zweiten Ausgang A des Asynchronzählers AZ gekoppelt.

Der Aufbau des Operationswerks OW kann entsprechend der verwendeten Variation des erfindungsgemäßen Verfahrens ebenso variieren. Variationen des erfindungsgemäßen Verfahrens sowie die sich daraus ergebenden Variationen des Operationswerks OW werden im weiteren beschrieben.

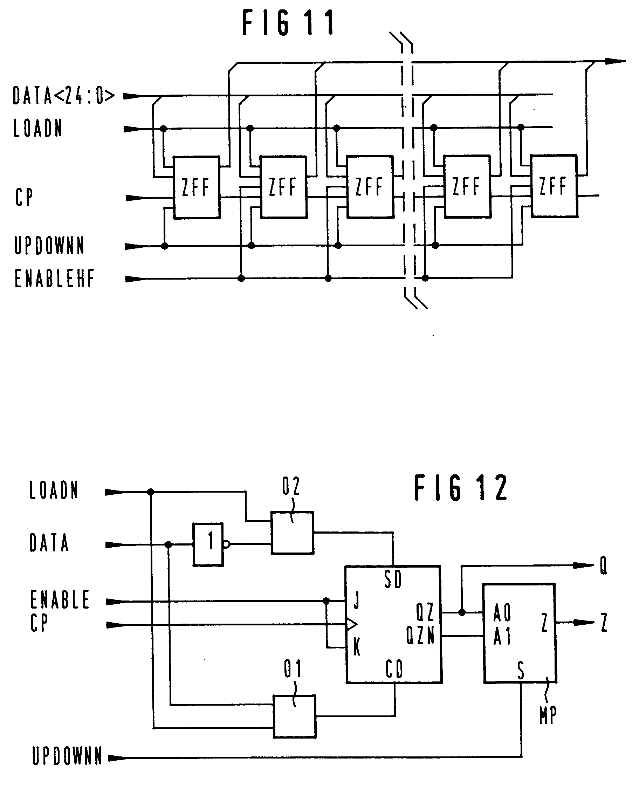

Bei diesem bevorzugten Ausführungsbeispiel weist der Asynchronzähler AZ eine Kette von 25 hintereinander geschalteten, speziellen Toggle-Flip-Flops auf, deren Aufbau in Figur 12 dargestellt ist.

In Figur 11 ist der spezielle Aufbau des Asynchronzählers AZ dargestellt. Zu Beginn eines jeden Meßzyklus wird jeweils mit der Vorderflanke eines Signals LOADN der Inhalt des Offset-Registers OR über den Dateneingang DATA in den Asynchronzähler AZ eingelesen. Das Signal UPDOWNN steuert die Zählrichtung des Asynchronzählers AZ. Durch ein Signal ENABLEHF wird der Asynchronzähler AZ während des Zählrichtungswechsels deaktiviert, um sicherzustellen, daß der aktuelle Zählerstand beim Umschalten der Zählrichtung unverändert erhalten bleibt. An dem zweiten Ausgang A des Asynchronzählers AZ kann der aktuelle Zählerstand des Asynchronzählers AZ abgefragt werden.

Ein bei dem bevorzugten Ausführungsbeispiel in dem Asynchronzähler AZ verwendeter Zählerbaustein ZFF hat, wie in Figur 12 dargestellt, folgenden Aufbau.

Ein JK-Flip-Flop ist sowohl mit einem ersten Anschluß J als auch mit einem zweiten Anschluß K an das Signal ENABLEHF gekoppelt. Ein Anschluß CD ist über ein erstes Oder-Gatter O1 zum einen mit einem Signal LOADN und zum anderen mit der Datenleitung des Dateneingangs DATA des Asynchronzählers AZ gekoppelt, die jeweils die Stelle des Zählerbausteines innerhalb des Asynchronzählers AZ repräsentiert.

Ein Anschluß SD des JK-Flip-Flops ist gekoppelt mit einem zweiten Oder-Gatter O2, an dessen Eingängen zum einen das Signal LOADN liegt und zum anderen das invertierte Signal liegt, das auf der jeweiligen Leitung des Dateneingangs DATA des Asynchronzählers AZ anliegt. Das JK-Flip-Flop ist mit einem Ausgang QZ an einen ersten Eingang A0 eines Multiplexers MP gekoppelt. Ein negierter Ausgang QZN des JK-Flip-Flops liegt an einem zweiten Eingang A1 des Multiplexers MP.

Je nachdem, ob das Signal UPDOWNN logisch 0 oder logisch 1 ist, wird entweder ein an dem Ausgang QZ des JK-Flip-Flops liegendes Signal oder ein an dem negierten Ausgang QZN anliegendes Signal auf einen Ausgang Z des Multiplexers MP durchgeschaltet.

Eine Möglichkeit, den Kapazitätsunterschied zwischen der ersten Kapazität $C_1$ und der zweiten Kapazität $C_2$ zu messen, liegt z. B. in dem im folgenden beschriebenen Verfahren.

Zu Beginn des Verfahrens wird die Störkapazität $C_P$ isoliert gemessen, indem die Schaltereinheit S in die erste Schalterposition S1 gebracht wird. Dadurch werden alle parasitären Effekte, die durch eine Störkapazität $C_P$ am Eingang ERG des Rechteck-Generators RG modelliert werden können, isoliert in dieser Schalterposition gemessen.

Die Schaltereinheit S bleibt für die Länge eines ersten Teilzyklus T1 in der ersten Schalterposition S1. Jeder Teilzyklus, der durch den Periodenzähler PZ gesteuert wird, hat jeweils die Länge von N Takten.

In dem ersten Teilzyklus T1 wird die Zählrichtung des Asynchronzählers AZ so eingestellt, daß der Asynchronzähler AZ rückwärts zählt. Der HF-Oszillator HF wird über das Und-Gatter auf den Asynchronzähler AZ durchgeschaltet, sobald die Schaltereinheit S eine Kapazität ausgewählt hat und der Meßoszillator MO eingeschwungen ist.

Die Sicherstellung, daß der Meßoszillator sich in einem eingeschwungenen Zustand befindet, kann z. B. dadurch erreicht werden, daß einfach eine Periode des Rechteck-Generators RG gewartet wird, bis der HF-Oszillator HF auf den Asynchronzähler AZ durchgeschaltet wird. Durch diese Maßnahme werden Umschaltfehler eliminiert. Andere Maßnahmen, z. B. ein anderes Maß zur Festlegung der Zeit, bis der HF-Oszillator HF auf den Asynchronzähler AZ durchgeschaltet wird, sind dem Fachmann bekannt und können ohne Probleme von einem Fachmann implementiert werden.

Nach dem ersten Teilzyklus T1 enthält der Asynchronzähler AZ einen Wert, der die negative Störkapazität $C_P$ repräsentiert.

In einem zweiten Teilzyklus T2, der ebenfalls N Takte lang dauert, wird die Schaltereinheit S in die zweite Schalterposition S2 gebracht, wodurch die gestörte erste Kapazität $C_1'$ an den Rechteck-Generator RG durchgeschaltet wird. Die gestörte erste Kapazität $C_1'$ ergibt sich aus der Summe der ersten Kapazität $C_1$ und der Störkapazität $C_P$. In dem zweiten Teilzyklus T2 wird die Zählrichtung des Asynchronzählers AZ von dem Steuerwerk ST so eingestellt, daß der Asynchronzähler AZ vorwärts zählt.

Wiederum wird der Ausgangstakt des HF-Oszillators HF über das Und-Gatter auf den Asynchronzähler AZ durchgeschaltet. Somit zählt der Asynchronzähler AZ in dem zweiten Teilzyklus T2 solange, bis ein Wert erreicht wird, der den Wert der gestörten ersten Kapazität $C_1'$ repräsentiert. Da der Zählerstand des Asynchronzählers AZ zu Beginn des zweiten Teilzyklus T2 auf einem die negative Störkapazität $C_P$ repräsentierenden Wert war, repräsentiert der Zählerstand des Asynchronzählers AZ nach dem zweiten Teilzyklus T2 genau den Wert der ersten Kapazität $C_1$, da gilt:

$$-C_P + C_1' = -C_P + C_1 + C_P = C_1.$$

Nun wird der die erste Kapazität $C_1$ repräsentierende Wert aus dem Asynchronzähler AZ ausgelesen und mit dem Faktor 2 multipliziert. Dieser Wert wird in dem ersten Register R1 gespeichert. In einem nun folgenden dritten Teilzyklus T3 der ebenfalls N Takte lang dauert, wird die Schaltereinheit S in die dritte Schalterposition S3 gebracht, wodurch die gestörte zweite Kapazität $C_2'$ an den Rechteck-Generator RG durchgeschaltet wird. Wieder wird die Zählrichtung des Asynchronzählers AZ so eingestellt, daß der Asynchronzähler AZ vorwärtszählt.

Nach dem dritten Teilzyklus T3 enthält der Asynchronzähler AZ also einen Wert, der den Term C1 + C2 + CP repräsentiert, da gilt:

$$C_1 + C_2' = C_1 + C_2 + C_P.$$

In einem vierten Teilzyklus T4 wird die Schaltereinheit S wieder in die erste Schalterposition S1 gebracht, womit wiederum nur die Störkapazität CP isoliert gemessen wird.

Da der Asynchronzähler AZ in dem vierten Teilzyklus T4 rückwärts zählt, weist der Asynchronzähler AZ nach dem vierten Teilzyklus T4 einen Zählerstand auf, der den Term C1 + C2 repräsentiert, also die Summe der ersten Kapazität $C_1$ und der zweiten Kapazität $C_2$, da gilt:

$$C_1 + C_2 + C_P - C_P = C_1 + C_2.$$

Damit wurden alle parasitären Effekte, die durch die Störkapazität $C_P$ modelliert werden können, kompensiert. Der Wert des Asynchronzählers AZ, der nun die Summe aus der ersten Kapazität $C_1$ und der zweiten Kapazität $C_2$ repräsentiert, wird in dem zweiten Register R2 gespeichert.

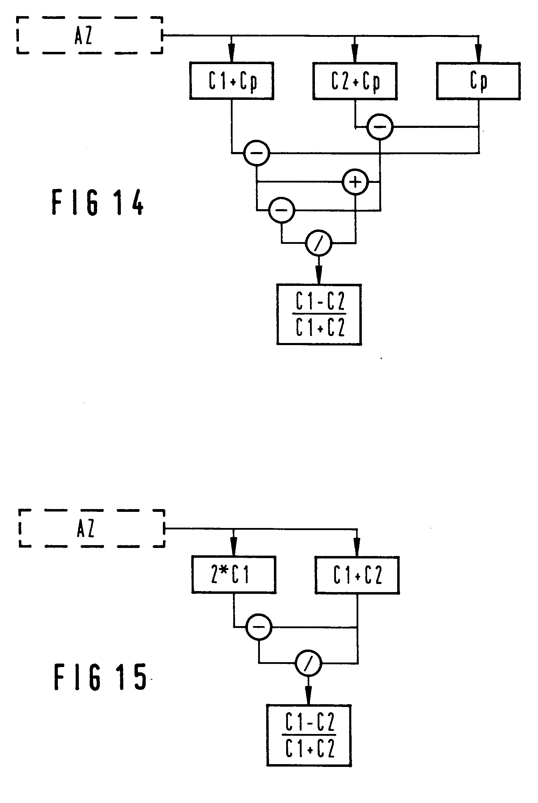

In Figur 15 ist dargestellt, wie durch das im vorigen beschriebene Verfahren der Term

$$\frac{C_1 - C_2}{C_1 + C_2},$$

der einen relativen Kapazitätsunterschied zwischen der ersten Kapazität $C_1$ und der zweiten Kapazität $C_2$ beschreibt, im Vergleich zur üblicherweise verwendeten Berechnungsmethode, wie in Figur 14 dargestellt, vereinfacht wird.

Abweichende Verfahrensschritte von dem im vorigen beschriebenen Verfahren, indem z. B. der Asynchronzähler AZ niemals rückwärts zählt, sondern jeweils nach einem Teilzyklus zurückgesetzt wird und der Wert am Ende eines Teilzyklus in einem eigenen Register zwischengespeichert wird, und die weitere Berechnung anhand der zwischengespeicherten Werte in den verschiedenen Registern durchgeführt wird, sind dem Fachmann bekannt.

Entsprechend solcher elementaren Änderungen des erfindungsgemäßen Verfahrens ändert sich selbstverständlich auch die erfindungsgemäße Schaltungsanordnung. Somit erstreckt sich die erfindungsgemäße Schaltungsanordnung nicht nur auf das beschriebene bevorzugte Ausführungsbeispiel.

**Offset-Kompensation**

Um eine Offset-Kompensation zu erreichen, was insbesondere bei Differentialkondensatoren vorteilhaft ist, wird die negative Differenz zwischen beiden Kapazitäten, also zwischen der ersten Kapazität $C_1$ und der zweiten Kapazität $C_2$, in Ruhelage gebildet. Dieser Wert wird anschließend von Zähler und Nenner des Quotienten

$$\frac{C_1 - C_2}{C_1 + C_2}$$

abgezogen.

Dies geschieht durch Vorbelegung des Asynchronzählers AZ mit der negativen Kapazitätsdifferenz zu Beginn eines jeden Meßzyklus. Damit wird der Fehler, der durch eine nicht ideale Ruhelage eines Differentialkondensators entsteht, reduziert.

Unter einer idealen Ruhelage ist zu verstehen, daß beide Kapazitäten, also die erste Kapazität $C_1$ und die zweite Kapazität $C_2$, gleich sind. In der Realität befindet sich allerdings die Mittelelektrode eines Differentialkondensators immer etwas von der Mitte des Differentialkondensators entfernt, wodurch es zu dem Offset kommt, der durch das im vorigen beschriebene Verfahren allerdings reduziert werden kann.

**Patentansprüche**

1. Schaltungsanordnung zum Messen eines Kapazitätsunterschiedes zwischen einer ersten Kapazität ($C_1$) und einer zweiten Kapazität ($C_2$),

   - bei der eine Schaltereinheit (S) vorgesehen ist, die je nach Schalterstellung mit der ersten Kapazität ($C_1$), der zweiten Kapazität ($C_2$) oder mit keiner der beiden Kapazitäten verbunden ist, die von einem Periodenzähler (PZ) über einen ersten Ausgang (A1PZ) des Periodenzählers (PZ) gesteuert wird,
   - bei der ein mit der Schaltereinheit (S) verbundener Rechteck-Generator (RG) vorgesehen ist, der ein Rechtecksignal mit einer von der anliegenden Kapazität abhängigen Frequenz liefert, und an dessen Eingang jeweils die Kapazität anliegt, die durch die Schaltereinheit (S) ausgewählt ist
   - bei der ein Eingang (EPZ) des Periodenzählers (PZ) mit einem Ausgang (AMO) des Meßoszillators (MO) gekoppelt ist,
   - bei der über einen zweiten Ausgang (A2PZ) des Periodenzählers (PZ) die Anzahl der von dem Meßoszillator (MO) in einem Teilzyklus von N Takten eines Meßzyklus gelieferten Rechtecksignale zur Verfügung gestellt ist, und
   - bei der eine mit dem zweiten Ausgang (A2PZ) des Periodenzählers (PZ) gekoppelte Auswertelogik (AL) vorgesehen ist zur Berechnung des Kapazitätsunterschieds zwischen der ersten Kapazität ($C_1$) und der zweiten Kapazität ($C_2$), wobei einer Zeitdauer des jeweiligen Teilzyklus ein der Zeitdauer proportionaler Wert zugeordnet wird, woraus der Kapazitätsunterschied ermittelt wird.

2. Schaltungsanordnung nach Anspruch 1, bei der der Periodenzähler (PZ) eine variable Bitlänge aufweist.

3. Schaltungsanordnung nach Anspruch 1 oder 2, bei der die Auswertelogik (AL) in analoger Form realisiert ist.

4. Schaltungsanordnung nach Anspruch 1 oder 2, bei der die Auswertelogik (AL) in digitaler Form realisiert ist.

5. Schaltungsanordnung nach Anspruch 4,

   - bei der die digitale Auswertelogik (AL) ein Steuerwerk (ST) aufweist, das die Zählrichtung eines Asynchronzählers (AZ) bestimmt, und
   - bei der der mit dem Steuerwerk (ST) gekoppelte Asynchronzähler (AZ) über ein UND-Gatter mit einem HF-Oszillator (HF) gekoppelt ist.

6. Schaltungsanordnung nach Anspruch 5, bei der die digitale Auswertelogik (AL) ein Operationswerk (OW) aufweist, die mit dem Asynchronzähler (AZ) und mit dem Steuerwerk (ST) gekoppelt ist.

7. Verfahren zum Messen eines Kapazitätsunterschiedes zwischen einer gestörten ersten Kapazität ($C_1{}'$) und einer gestörten zweiten Kapazität ($C_2{}'$), die unter dem Einfluß einer durch eine Störkapazität ($C_P$) modellierte Störgröße stehen, bei dem alternierend folgende Schritte vorgesehen sind, wobei die Kapazitätsmessungen mit Hilfe eines Meßoszillators (MO) erfolgen, der ein Rechtecksignal einer Frequenz (f) liefert, die abhängig ist von der jeweils zu messenden Kapazität:

- die Störkapazität ($C_P$) wird isoliert gemessen,
- die unter dem Einfluß der Störkapazität ($C_P$) stehende gestörte erste Kapazität ($C_1$') wird gemessen, wobei die gestörte erste Kapazität ($C_1$') sich ergibt aus der Summe der ersten Kapazität ($C_1$) und der Störkapazität ($C_P$),
- die unter dem Einfluß der Störkapazität ($C_P$) stehende gestörte zweite Kapazität ($C_2$') wird gemessen, wobei die gestörte zweite Kapazität ($C_2$') sich ergibt aus der Summe der zweiten Kapazität ($C_2$) und der Störkapazität ($C_P$), und
- bei dem der Kapazitätsunterschied zwischen der gestörten ersten Kapazität ($C_1$') und der gestörten zweiten Kapazität ($C_2$') unter Verwendung einer Auswertelogik (AL) ermittelt wird, wobei der jeweiligen Frequenz (f) ein der Frequenz (f) indirekt proportionaler Wert zugeordnet wird, woraus der Kapazitätsunterschied ermittelt wird.

8. Verfahren nach Anspruch 7,

- bei dem die Auswahl der zu messenden Kapazität durch eine Schaltereinheit (S) geschieht, die durch einen Periodenzähler (PZ) gesteuert wird,
- bei dem die Anzahl der in einem Teilzyklus mit N Takten Länge von dem Meßoszillator (MO) gelieferten Rechtecksignale von dem Periodenzähler (PZ) gezählt wird.

9. Verfahren nach Anspruch 7 oder 8, bei dem der Kapazitätsunterschied zwischen der gestörten ersten Kapazität ($C_1$') und der gestörten zweiten Kapazität ($C_2$') unter Verwendung einer digitalen Auswertelogik (AL) ermittelt wird.

10. Verfahren nach Anspruch 9, bei dem in der Auswertelogik (AL) zur Ermittlung des Kapazitätsunterschieds durch ein Steuerwerk (ST) ein Ausgangtakt eines HF-Oszillators (HF) über ein UND-Gatter auf einen Asynchronzähler (AZ) durchgeschaltet wird, der die Anzahl der Ausgangtakte zählt.

11. Verfahren nach Anspruch 10, bei dem der Ausgangtakt des HF-Oszillators (HF) durchgeschaltet wird, nachdem der Meßoszillator (MO) eingeschwungen ist.

12. Verfahren nach einem der Ansprüche 9 bis 11,

- bei dem bei der Ermittlung der Störkapazität ($C_P$) in einem ersten Teilzyklus (T1) der Asynchronzähler (AZ) rückwärts zählt,
- bei dem bei der Ermittlung der gestörten ersten Kapazität ($C_1$') in einem zweiten Teilzyklus (T2) der Asynchronzähler (AZ) vorwärts zählt,
- bei dem der nun in dem Asynchronzähler (AZ) stehende Wert der ersten Kapazität ($C_1$) aus dem Asynchronzähler (AZ) ausgelesen wird,
- bei dem der Wert der ersten Kapazität ($C_1$) mit einem Faktor 2 multipliziert wird,
- bei dem der mit dem Faktor 2 multiplizierte Wert der ersten Kapazität ($C_1$) in einem ersten Register (R1) abgespeichert wird,
- bei dem bei der Ermittlung der gestörten zweiten Kapazität ($C_2$') in einem dritten Teilzyklus (T3) der Asynchronzähler (AZ) vorwärts zählt,
- bei dem bei einer zweiten Ermittlung der Störkapazität ($C_P$) in einem vierten Teilzyklus (T4) der Asynchronzähler (AZ) rückwärts zählt,
- bei dem der Zählerstand des Asynchronzählers (AZ), der den Wert der Summe ($C_1$+$C_2$) der ersten Kapazität ($C_1$) und der zweiten Kapazität ($C_2$) enthält, ausgelesen wird,
- bei dem der Summenwert ($C_1$+$C_2$) in einem zweiten Register (R2) gespeichert wird, und
- bei dem in einer Recheneinheit (ALU) der Kapazitätsunterschied zwischen der ersten Kapazität (C1) und der zweiten Kapazität (C2) nach der Berechnungsvorschrift

$$\frac{C_1 - C_2}{C_1 + C_2}$$

berechnet wird.

13. Verfahren nach Anspruch 7 oder 8, bei dem der Kapazitätsunterschied zwischen der gestörten ersten Kapazität ($C_1$') und der gestörten zweiten Kapazität ($C_2$') unter Verwendung einer analogen Auswertelogik (AL) ermittelt

wird.

## FIG 1

## FIG 3

## FIG 4

# FIG 2

FIG 5

CLOCK

A0 A1 A2 A3 A4 A5 A6 A7 A8N A8 A9N A9

Z2 Z1 Z0

## F I G 6

Bit 9 8 | 7 6 5 4 3 2 1 0     Zaehlerbreite: 10Bit=>
Schalterwechsel: alle 256 Perioden

Bit 8 7 | 6 5 4 3 2 1 0     Zaehlerbreite: 9Bit=>
Schalterwechsel: alle 128 Perioden

Bit 7 6 | 5 4 3 2 1 0     Zaehlerbreite: 8Bit=>
Schalterwechsel: alle 64 Perioden

Bit 6 5 | 4 3 2 1 0     Zaehlerbreite: 7Bit=>
Schalterwechsel: alle 32 Perioden

## F I G 7

ZERO

ML

ZERO
TAKT
TAKTN
PHASE<7:0>
ZYK0
ZYK0N
ZYK1
ZYK1N

ST

SYNC
ENDIV
CLOCKDIV
LOADIV
OFFSUB
LOADCI
LOADC1PC2
LOADOFF
RSTOFFN
LOADHFN
UPDOWNN
ENABLEHF
ATTENTION

OW

16
PARAOUT<15:0>
SHIFTOUT
SEROUT

FIG 8

# FIG 9

# FIG 10

| LOADN | : Vorbelegungswert einlesen |
| UPDOWNN | : Steuerung der Zaehlrichtung |
| ENABLEHF | : Zaehleraktivierung |
| DATA | : Vorbelegungswert |

# FIG 11

DATA<24:0>
LOADN

CP

UPDOWNN
ENABLEHF

ZFF  ZFF  ZFF  ZFF  ZFF

# FIG 12

LOADN

DATA

ENABLE
CP

UPDOWNN

O2

O1

SD
J     QZ
      QZN
K
CD

AO
A1    Z

S

MP

Q

Z

# FIG 13

```
┌─────────────────────────────────────────────┐
│            Schalterposition 1               │── T1
│      keine ext. Kap. durchgeschaltet         │
│  HF-Zaehler zaehlt rueckwaerts mit Cp        │
└─────────────────────────────────────────────┘
                      │
                      ▼
┌─────────────────────────────────────────────┐
│            Schalterposition 2               │── T2
│         $C_1$+Cp durchgeschaltet             │
│      HF-Zaehler zaehlt vorwaerts             │
└─────────────────────────────────────────────┘
                      │
                      ▼
            ┌──────────────────┐
            │  2* C1 auslesen  │
            └──────────────────┘
                      │
                      ▼
┌─────────────────────────────────────────────┐
│            Schalterposition 3               │── T3
│         $C_2$+Cp durchgeschaltet             │
│      HF-Zaehler zaehlt vorwaerts             │
└─────────────────────────────────────────────┘
                      │
                      ▼
┌─────────────────────────────────────────────┐
│            Schalterposition 1               │── T4
│      keine ext. Kap. durchgeschaltet         │
│  HF-Zaehler zaehlt rueckwaerts mit Cp        │
└─────────────────────────────────────────────┘
                      │
                      ▼
            ┌──────────────────┐
            │  C1+C2 auslesen  │
            └──────────────────┘
                      │
                      ▼
```

FIG 14

FIG 15